(19) Europäisches Patentamt
European Patent Office
Office européen des brevets

(11) **EP 3 744 685 B1**

(12) **EUROPEAN PATENT SPECIFICATION**

(45) Date of publication and mention
of the grant of the patent:
**17.08.2022 Bulletin 2022/33**

(21) Application number: **19744324.5**

(22) Date of filing: **15.01.2019**

(51) International Patent Classification (IPC):
*C01B 33/18* [(2006.01)]  *C08K 3/36* [(2006.01)]
*C08L 101/00* [(2006.01)]  *H01L 23/29* [(2006.01)]
*H01L 23/31* [(2006.01)]

(52) Cooperative Patent Classification (CPC):
**H01L 23/295; C01B 33/18; C08K 3/36;**
C01P 2004/32; C01P 2004/61; C01P 2006/80;
C08K 2201/005

(86) International application number:
**PCT/JP2019/000974**

(87) International publication number:
**WO 2019/146454 (01.08.2019 Gazette 2019/31)**

(54) **AMORPHOUS SILICA POWDER, PRODUCTION METHOD THEREFOR, AND USE THEREOF**

AMORPHES SILICIUMOXIDPULVER, HERSTELLUNGSVERFAHREN DAFÜR UND VERWENDUNG DAVON

POUDRE DE SILICE AMORPHE, SA MÉTHODE DE PRODUCTION ET SON UTILISATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.01.2018 JP 2018011603**

(43) Date of publication of application:
**02.12.2020 Bulletin 2020/49**

(73) Proprietor: **Denka Company Limited
Tokyo 103-8338 (JP)**

(72) Inventors:
• **SASAKI, Shuji**
**Omuta-city, Fukuoka 836-8510 (JP)**
• **NITTA, Junya**
**Omuta-city, Fukuoka 836-8510 (JP)**
• **YAMAGUMA, Ryoma**
**Omuta-city, Fukuoka 836-8510 (JP)**
• **YOSHIGAI, Hiroaki**
**Omuta-city, Fukuoka 836-8510 (JP)**
• **MIYAZAKI, Koji**
**Omuta-city, Fukuoka 836-8510 (JP)**

(74) Representative: **Gulde & Partner
Patent- und Rechtsanwaltskanzlei mbB
Wallstraße 58/59
10179 Berlin (DE)**

(56) References cited:
EP-A2- 0 257 611       JP-A- 2005 187 302
JP-A- 2006 273 927    JP-A- 2007 145 880
JP-A- 2009 280 473    JP-A- 2010 285 307
JP-A- 2015 086 120    JP-A- 2019 019 222
JP-B2- 5 994 573

• Lei Xue ET AL: "Synthesis of Monodisperse Silica Microspheres by a Modified Stöber Method", INTEGRATED FERROELECTRICS, vol. 154, no. 1, 13 June 2014 (2014-06-13) , pages 142-146, XP055844084, US ISSN: 1058-4587, DOI: 10.1080/10584587.2014.904651
• He Jie ET AL: "Preparation and characterization of monodisperse porous silica microspheres with controllable morphology and structure", Journal of Polymer Science Part A: Polymer Chemistry, vol. 50, no. 14, 15 July 2012 (2012-07-15) , pages 2889-2897, XP055844089, US ISSN: 0887-624X, DOI: 10.1002/pola.26066 Retrieved from the Internet: URL:https://onlinelibrary.wiley.com/doi/full-xml/10.1002/pola.26066>

**Description**

Technical Field

The present invention relates to an amorphous silica powder, a production method thereof, and the use thereof.

Background Art

In response to the demand for smaller and lighter electronic devices and higher performance thereof, the miniaturization, thinning, and high-density mounting of semiconductors are rapidly advancing. Thus, for the structure of the semiconductor, an area array type that is advantageous for thinning and high-density mounting is increasing as compared with a conventional lead frame type. Furthermore, in recent years, a stacked chip structure or a multiple chip structure in which multiple IC chips are stacked and mounted in one semiconductor package has also been actively adopted, and the semiconductor structure is becoming more complicated and high-density mounting is increasingly in progress. In addition, with the trend of miniaturization, thinning, and high-density mounting of semiconductors, the wiring interval between gold wires inside a semiconductor is also becoming narrower, and those having a gold wire interval of about 50 $\mu$m have been put to practical use.

In semiconductor sealing materials for packaging (sealing) semiconductors, epoxy resin is filled with inorganic powder, particularly an amorphous silica powder to impart properties such as low thermal expansion, solder heat resistance, and electrical insulation, but fine metal particles may contaminate as foreign matters the amorphous silica powder in the production process thereof. This is because a part of the production equipment for the amorphous silica powder is typically made of metals such as iron and stainless steel and the surface thereof is shaven by the powder when the above powder is pulverized, transported by an air stream, classified, sieved, or blended. As described above, when the metallic foreign matters contaminates the amorphous silica powder filled in the semiconductor sealing material, it is more likely that a short circuit ("short") is induced between wires such as semiconductor wires. Most of these metallic particles are made of magnetizable particles, and various attempts have been made to remove the magnetizable particle contaminants in the amorphous silica powder.

As a technique for removing magnetizable particles in the amorphous silica powder, a method of dissolving and removing metallic powder by putting spherical silica powder including metallic particles in sulfuric acid aqueous solution is disclosed (Patent Literature 1). However, the conventional method has problems of not only much cost for requirement of washing, heat drying, and crushing the acid-treated spherical silica powder but also of high risk of recontamination with metal particles in a heat drying step and a crushing step for powdering. The remaining sulfate ions also causes a problem that the reliability of the semiconductor sealing material filled with the spherical silica powder is reduced. In addition, a method of dispersing nonmagnetic metal oxide powder in an organic solvent or hot water more than 60°C and removing magnetizable particles by contacting with a magnet is disclosed (Patent Literature 2). However, the conventional method requires much cost in using an organic solvent, and may provide an adverse effect on the properties of the semiconductor sealing material because the functional groups of the used organic solvent may mask the surface of the inorganic powder when heating and drying are performed directly after removing the magnetizable particles. In using hot water which occurs solid aggregation of powders due to heating and drying, there is a problem that an increase in the flow pressure at sealing of the semiconductor sealing material filled with the inorganic powder deforms thinned gold wire, causing a trouble of so-called wire flow. Therefore, the most advanced semiconductor sealing material requires not only significantly few magnetizable particles and but also high moldability with a small amount of wire flow to achieve high insulation reliability, but there is still no semiconductor sealing material having the property of sufficiently satisfying these requirements. Patent Literatures 3, 4 and 5 and Non-patent Literatures 1 and 2 disclose further silica powders and methods of manufacturing thereof.

Citation List

Literature

Patent Literature 1: JP 2007-005346 A
Patent Literature 2: JP 2005-187302 A
Patent Literature 3: EP 0 257 611 A2
Patent Literature 4: JP 2010 285307 A
Patent Literature 5: JP 5 994573 B2

Non-Patent Literature 1: Lei Xue et al.; "Synthesis of Monodisperse Silica Microspheres by a Modified Stöber Method", Integrated Ferroelectrics, vol. 154, No. 1, 2014, 142-146
Non-Patent Literature 2: He Jie et al.; "Preparation and characterization of monodisperse porous silica microspheres with controllable morphology and structure", J. Polymer Sci. Part A: Polymer Chem., vol. 50, no. 14, 2012, 2889-2897

Summary of Invention

Technical Problem

The object of the present invention is to provide an amorphous silica powder having extremely high insulation reliability and capable of preparing a semiconductor sealing material having high moldability, and is to provide a resin composition containing the same.

Solution to Problem

The present inventor has made intensive investigations to achieve the above object, and has found the amorphous silica powder that achieves the goal. The present invention is based on such findings, and may provide the following aspects.

(1) An amorphous silica powder having an average particle size of 20 $\mu$m or more and 35 $\mu$m or less, wherein the percent retention of 250 $\mu$m or more by dry sieving is 5.0% by mass or less, and the number of magnetizable particles having a size of 45 $\mu$m or more is zero as measured by the following method.

[Method of measuring magnetizable particles]

50 g of an amorphous silica powder and 800 g of ion exchange water are added in a 1000 mL beaker to prepare a slurry. The slurry is stirred by a stirring device at a rotation speed of 550 rpm and with reverse rotation at intervals of 5 seconds, while a bar magnet having a length of 150 mm, a diameter of 25 mm, and a magnetic force of 12000 gausses which is covered with a rubber cover having a thickness of 20 $\mu$m is immersed therein for 1 minute to capture magnetizable particles. The bar magnet capturing the magnetizable particles is removed from the slurry, and the rubber cover is removed from the magnet bar above an empty beaker, and washed with ionexchange water to detach the magnetizable particles, which are then dispersed in water. The resulting dispersion is loaded on a suction filtration device equipped with a 25 mm diameter nylon filter (sieve opening: 35 $\mu$m) to collect the magnetizable particles on the nylon filter. The nylon filter having the collected magnetizable particles is set on a microscope, and the number of magnetizable particles having a size of 45 $\mu$m or more is measured among the magnetizable particles collected on the nylon filter while moving the entire area of the filter at a magnification of 100 times.

(2) The amorphous silica powder according to the above (1), wherein a maximum particle size is 75 $\mu$m or less.

(3) The amorphous silica powder according to the above (1) or (2), wherein an average sphericity of the particles having a size of 10 $\mu$m or more is 0.80 or more.

(4) A method of producing the amorphous silica powder according to the above (1) to (3), comprising the steps of: using water at 60°C or less to prepare a water slurry having an amorphous silica powder concentration of 40% by mass or less;

circulating the water slurry from bottom to top at a flow rate of 0.2 cm/s or more and 5 cm/s or less through a magnetic separation zone in a circulation line having the magnetic separation zone, in which 10 or more screens having a aperture of 0.5 mm or more and 15 mm or less and each having a magnetic force of 14000 gausses or more are vertically stacked, to remove magnetizable particles included in the amorphous silica powder; and
feeding a water slurry containing the amorphous silica powder after removal of the magnetizable particles through a center portion of a two-fluid nozzle from a container set to 130°C or higher and 300°C or lower of inside temperature and having the two-fluid nozzle provided at the upper portion, and at the same time injecting dry air through an outer portion of the two-fluid nozzle to spray-dry the slurry at a spray speed of slurry droplets of 50 m/s or more and 250 m/s or less.

(5) A resin composition comprising the amorphous silica powder according to any one of the above (1) to (3) .

(6) A semiconductor sealing material comprising the resin composition according to the above (5).

Advantageous Effects of Invention

The present invention provides an amorphous silica powder and a resin composition thereof capable of preparing a semiconductor sealing material having extremely high insulation reliability and high moldability.

Description of Embodiments

Hereinafter, the present invention will be described in detail.

The average particle size of the amorphous silica powder according to the embodiment of the present invention needs to be 20 $\mu$m or more and 30 $\mu$m or less. If the average particle size is less than 3 $\mu$m, fine particles becomes too many, and when the powder is filled in the resin, the viscosity of the semiconductor sealing material increases and the amount of wire flow increases. On the other hand, if the average particle size is more than 50 $\mu$m, the ratio of particles having a relatively large particle size becomes too large, and the frequency of collision of these particles having a large particle size with the gold wire increases, especially resulting in increasing the amount of wire flow.

In the present description, the average particle size of the amorphous silica powder is a value based on the mass-based particle size measurement by a laser diffraction-scattering method, and is measured with "Microtrac MT3300EX2" manufactured by Microtrac Bell Inc. Amorphous silica powder is dispersed in 1% by mass of an aqueous solution of sodium hexametaphosphate. The circulation speed of the apparatus is set to 80, and the sample to be measured is put therein such that the concentration is within an appropriate range. After dispersion for 240 seconds at an ultrasonic power of 40 W, the measurement is performed. The particle size distribution measurement is performed with the particle size channels of 0.1, 0.7, 1, 1.5, 2, 3, 4, 6, 8, 12, 16, 24, 32, 48, 64, 96, 128, and 192 $\mu$m. In the measured particle size distribution, the particle size at which the cumulative mass becomes 50% is the average particle size.

The amorphous silica powder according to the embodiment of the present invention needs to have a percent retention of 250 $\mu$m or more by dry sieving of 5% by mass or less. In this description, the "percent retention of 250 $\mu$m or more by dry sieving" refers to a percentage of particles having a particle size of 250 $\mu$m or more retained without passing through a dry sieve having an aperture of 250 $\mu$m (that is, oversize). A high percent retention by dry sieving means that many aggregates are included, and if the percent retention of 250 $\mu$m or more by dry sieving is more than 5.0% by mass, the amorphous silica, as filled in a resin and used as a semiconductor sealing material, is less dispersible, thereby raising the viscosity of the semiconductor sealing material and increasing the amount of wire flow. The percent retention of 250 $\mu$m or more by dry sieving is more preferably 3.0% by mass or less, and further preferably less than 0.5% by mass.

In this description, the percent retention of 250 $\mu$m or more by dry sieving of the amorphous silica powder is measured by the following method. A sieve having an aperture of 250 $\mu$m is set in a powder tester ("PT-E type" manufactured by Hosokawa Micron Corporation). 2 g of an amorphous silica powder is placed gently on the sieve and the sieve amplitude is set to 1 mm to perform vibration for 60 seconds, and then the mass of the amorphous silica powder retained on the 250 $\mu$m sieve is measured and the percent retention of 250 $\mu$m or more by dry sieving is calculated by the following formula.

```
Percent retention of 250 μm or more by dry sieving (% by

mass) = A/2×100
```

A in the formula is as follows.

A: mass of the amorphous silica powder retained on the 250 $\mu$m sieve (g)

To achieve the effect of causing no short circuit between semiconductor wires, the amorphous silica powder according to the embodiment of the present invention needs to have zero of the number of magnetizable particles having a size of 45 $\mu$m or more, as measured by the following method.

[Method of measuring magnetizable particles]

50 g of an amorphous silica powder and 800 g of ion exchange water are added in a 1000 mL beaker to prepare a slurry. The slurry is stirred by a stirring device at a rotation speed of 550 rpm and with reverse rotation at intervals of 5 seconds, while a bar magnet having a length of 150 mm, a diameter of 25 mm, and a magnetic force of 12000 gausses which is covered with a rubber cover having a thickness of 20 $\mu$m is immersed therein for 1 minute to capture magnetizable particles. The bar magnet capturing the magnetizable particles is removed from the slurry, and the rubber cover is removed from the magnet bar above an empty beaker, and washed with ionexchange water to detach the magnetizable particles, which are then dispersed in water. The resulting dispersion is loaded on a suction filtration device equipped with a 25 mm diameter nylon filter (sieve opening: 35$\mu$m) to collect the magnetizable particles on the nylon filter. The nylon filter having the collected magnetizable particles is set on a microscope, and the number of magnetizable particles having a size of 45 $\mu$m or more is measured among the magnetizable particles collected on the nylon filter while moving the entire area of the filter at a magnification of 100 times.

The amorphous silica powder has the number of magnetizable particles having a size of 45 $\mu$m or more of zero as measured by the above method, allowing to significantly reduce the possibility of occurrence of a short circuit failure of a semiconductor in being filled in a resin and used as a semiconductor sealing material. When the magnetic force of the bar magnet is less than 12000 gausses, or when the thickness of the material to be covered on the bar magnet is more than 20 $\mu$m, magnetizable particles having weak magnetism are hardly captured. Therefore, even when the amorphous silica powder has zero of the number of magnetizable particles having a size of 45 $\mu$m or more measured under conditions other than the above measurement method, the effect of improving the short circuit failure of a semiconductor is insufficient. In the present description, magnetizable particles are defined as magnetic particles captured by a bar magnet having a magnetic force of 12000 gausses in the above measurement method for magnetizable particles, and the particle size of the magnetizable particles is the longest size of each magnetic particle collected on the nylon filter.

The maximum particle size of the amorphous silica powder according to the embodiment of the present invention may preferably be 75 $\mu$m or less. If the maximum particle size is 75 $\mu$m or less, the particle is hard to collide with the thinned gold wire in filling the powder in a resin and using as a semiconductor sealing material, exhibiting the effect of suppressing the wire flow. A maximum particle size may more preferably be 63 $\mu$m or less.

In the present description, the maximum particle size of the amorphous silica powder is measured by the following wet sieving method. JIS standard sieves having apertures such as 90 $\mu$m, 75 $\mu$m, 63 $\mu$m, and 53 $\mu$m are set in a sieve shaking machine "Octagon Digital (wet sieve unit)" manufactured by Seishin Enterprise Co., Ltd., a finely weighed 10 g of the amorphous silica powder is put on the sieve, and vibration is performed for 5 minutes with a shower water rate of 9.5 liters/minute, and then the powder retained on the sieve is transferred to an aluminum container and is dried in the air at 120°C for 30 minutes to measure the mass of the powder on the sieve. The mass of the powder on the sieve is divided by the mass of the amorphous silica powder used for the measurement to calculate the percentage of the powder retained on the sieve. Here, the aperture of such a sieve that the percentage of the powder retained thereon is 0.5% by mass or less is defined as the maximum particle size of the amorphous silica powder.

In the amorphous silica powder according to the embodiment of the present invention, the average sphericity of particles having a particle size of 10 $\mu$m or more is preferably 0.80 or more. As the average sphericity is higher, the viscosity of the sealing material decreases when the power is filled in the resin, and the amount of wire flow in sealing may be reduced. The average sphericity is more preferably 0.83 or more.

In the present specification, the average sphericity of the amorphous silica powder is measured by the following method. Amorphous silica powder and ethanol were mixed to prepare a slurry of 1% by mass of the amorphous silica powder, and dispersion treatment is performed at output level 8 for 2 minutes by using "SONIFIER450 (crushing horn 3/4" solid type)" manufactured by Branson co., Ltd. The dispersion slurry is dropped on a sample table applied with a carbon paste with a dropper. The sample powder dropped on the sample table is left in the air until it dries, then osmium coating was performed, and an image with a magnification of 500 times and a resolution of 2048x1536 pixels taken with a scanning electron microscope "JSM-6301F type" manufactured by JEOL Ltd. is taken into a personal computer. The particles in this image are recognized by using an easy capture tool of an image analysis device "MacView Ver.4" manufactured by Mountech co., Ltd., and the sphericity is measured from the projected area (A) and the perimeter (PM) of the particles. Assuming that the area of a perfect circle corresponding to the perimeter (PM) is (B), the sphericity of the particle is A/B, and assuming a perfect circle (radius r) having the same perimeter as the perimeter (PM) of the sample, PM = $2\pi r$ and B = $\pi r^2$, and therefore B = $\pi \times (PM/2\pi)^2$ and the sphericity of individual particle is sphericity = A/B = A $\times 4\pi/ (PM)^2$. The thus obtained sphericity of 200 particles having an arbitrary projected area circle equivalent diameter of 10 $\mu$m or more is determined, and the average value is defined as the average sphericity.

The amorphous silica powder according to the embodiment of the present invention preferably has an amorphous proportion (melting proportion) of 98% or more. In the present description, the amorphous proportion of the amorphous silica powder is measured by using a powder X-ray diffractometer "Model: Mini Flex" manufactured by RIGAKU Co., Ltd. X-ray diffraction analysis is performed in the range of $2\theta$ of CuK$\alpha$ ray of 26° to 27.5°, and the measurement is performed from the intensity ratio of the specific diffraction peak. In the case of silica powder, crystalline silica has a main peak at 26.7°, but amorphous silica has no peak. When amorphous silica and crystalline silica are present together, a peak at 26.7° being a height corresponding to the proportion of crystalline silica is obtained, and therefore the proportion of crystalline silica inclusion, i.e., (X-ray diffraction intensity of the sample) / (X-ray intensity diffraction of the crystalline silica), is calculated from the ratio of the X-ray intensity of the sample to the X-ray intensity of the crystalline silica standard sample, and the amorphous proportion may be determined from the following formula:

$$\text{Amorphous proportion (\%) = (1 - (proportion of}$$

$$\text{crystalline silica inclusion)) × 100}$$

A method of producing the amorphous silica powder according to the embodiment of the present invention will be described.

The powder before the removal of the magnetizable foreign matters in the amorphous silica powder may be produced by any method as long as it has properties relating to a predetermined particle size. As an example, in a facility consisting of a melting furnace capable of forming a high-temperature flame and injecting silica powder raw material and a collection system for the melted product, the amorphous silica powder with various particle size configurations is produced by adjusting the conditions such as the particle size of silica powder raw material, raw material supply amount, furnace temperature, furnace pressure, and furnace air volume, and it may be produced by further classifying, sieving, and mixing. There are many known techniques for the configuration of the above facility (for example, refer to the description in Japanese Patent Laid-Open No. H11-057451), and any of them may be adopted.

As a method of removing magnetizable particles included in the amorphous silica powder, contact sorting of manufacturing a water slurry containing the amorphous silica powder and circulating it through high magnetic screens to remove magnetizable particles is most effective. The aperture of the screens is preferably 0.5 mm or more and 15 mm or less. Here, when the aperture of the screens is rectangular, the length of the short side is regarded as the aperture. If the aperture of the screens is less than 0.5 mm, the amorphous silica powder slurry is clogged on the screens, failing to remove magnetizable particles. On the other hand, if the screen aperture is more than 15 mm, the frequency of contact between magnetizable particles and the screens decreases, and therefore the magnetizable particles may be insufficiently removed, making it difficult to obtain the amorphous silica powder of the present invention. In addition, the magnetic force of each screen is preferably 14000 gausses or more. If the magnetic force of each screen is less than 14000 gausses, complete removal of weakly magnetizable particles, among the magnetizable particles, is very unlikely, making it difficult to obtain the amorphous silica powder of the present invention. When screens having an aperture of 0.5 mm or more and 15 mm or less and a magnetic force of 14000 gausses or more are used, circulating through this magnetic separation zone may remove magnetizable particles regardless of the number of screens, and considering the removal efficiency, a magnetic separation zone is preferably formed by stacking 10 or more screens.

In the preparation of the above water slurry, it is necessary to use water at 60°C or less, preferably cold water, so that no aggregation of particles occur after the water slurry is dried. In the present specification, "cold water" means liquid water at 30°C or less, more preferably water at 20°C or more and 30°C or less, for example, it may be water at 25°C.

The concentration of the amorphous silica powder in the water slurry containing the amorphous silica powder is preferably 40% by mass or less. When the concentration of the amorphous silica powder is more than 40% by mass, the removal efficiency of magnetizable particles in the magnetic separation zone decreases, making it difficult to remove magnetizable particles having a size of 45 $\mu$m or more. In addition, this water slurry containing the amorphous silica powder is preferably passed through the magnetic separation zone from bottom to top at a flow rate of 0.2 cm/s or more and 5 cm/s or less. If the flow rate is less than 0.2 cm/s, the water slurry containing the amorphous silica powder is clogged on the screens, failing to remove magnetizable particles. On the other hand, if the flow rate is more than 5 cm/s, magnetizable particles once captured by the screens are very likely to be detached by high flow rate, making it difficult to obtain desirable amorphous silica powder.

In drying the water slurry containing the amorphous silica powder from which magnetizable particles have been removed, a method of reducing the generation of aggregates is preferable. Specific examples include freeze-drying, reduced-pressure drying, and spray-drying, and among them, the spray-drying method is most preferable from the viewpoint of the aggregation suppressing effect and the drying efficiency.

When spray drying is performed, the temperature in the container is preferably set to 130°C or more and 300°C or less. When the temperature in the container is less than 130°C, the ability to evaporate water is insufficient, making it difficult to perform slurry drying. On the other hand, a high temperature in the container has no problem of slurry drying itself, but when the temperature is too high, silanol groups on the surface of the amorphous silica powder disappear, which may affect the surface properties, and in order to prevent this, the temperature is preferably set to 300°C or less.

In performing spray drying, the water slurry containing the amorphous silica powder after removal of magnetizable particles is fed through the feeding center portion of a two-fluid nozzle provided at the upper portion of a container, and when the dry air is injected through the outer portion of the two-fluid nozzle, the spray speed of the slurry droplets is preferably 50 m/s or more and 250 m/s or less. If the spray speed is less than 50 m/s, the slurry droplets become too large, and therefore aggregates tend to be generated when the slurry is dried, making it difficult to obtain desirable amorphous silica powder. On the other hand, if the spray speed of the slurry is more than 250 m/s, the passing speed in the container becomes too fast, and therefore the water does not evaporate sufficiently, making it difficult to dry the slurry.

In the embodiment of the present invention, a resin composition containing the above amorphous silica powder may also be provided. The content of the amorphous silica powder in the resin composition is preferably 10 to 95% by mass, and more preferably 30 to 93% by mass.

As a resin, epoxy resin, silicone resin, phenol resin, melamine resin, urea resin, unsaturated polyester, fluororesin, polyimide, polyamides such as polyamideimide and polyetherimide, polyesters such as polybutylene terephthalate and polyethylene terephthalate, polyphenylene sulfide, aromatic polyester, polysulfone, liquid crystal polymer, polyether sulfone, polycarbonate, maleimide modified resin, ABS resin, AAS (acrylonitrile-acrylic rubber-styrene) resin, and AES (acrylonitrile-ethylene-propylene-diene rubber-styrene) resin may be used.

Among these, an epoxy resin having two or more of epoxy groups in one molecule is preferable as the semiconductor sealing material. Examples of the epoxy resin may include phenol novolak epoxy resin, orthocresol novolak epoxy resin, epoxidized novolak resin of phenols and aldehydes, glycidyl ethers such as bisphenol A, bisphenol F, and bisphenol S, glycidyl ester acid epoxy resin obtained by reaction of polybasic acid such as phthalic acid or dimer acid with epichlorohydrin, linear aliphatic epoxy resin, alicyclic epoxy resin, heterocyclic epoxy resin, alkyl-modified polyfunctional epoxy resin, $\beta$-naphthol novolak epoxy resin, 1,6-dihydroxynaphthalene epoxy resin, 2,7-dihydroxynaphthalene epoxy resin, bishydroxybiphenyl type epoxy resin, and further epoxy resin introduced with halogens such as bromine to impart flame retardancy. Among them, from the viewpoint of moisture resistance and solder reflow resistance, orthocresol novolak epoxy resin, bishydroxybiphenyl epoxy resin, and naphthalene skeleton epoxy resin are suitable.

If the resin composition is an epoxy resin composition, the resin composition includes a curing agent for the epoxy resin. Examples of the curing agent for the epoxy resin may include: novolac resins such as phenol novolak, cresol novolak, and phenol aralkyl; polyparahydroxystyrene resin; bisphenol compounds such as bisphenol A and bisphenol S; trifunctional phenols such as pyrogallol and phloroglucinol; acid anhydrides such as maleic anhydride, phthalic anhydride, and pyromellitic anhydride; and aromatic amines such as metaphenylenediamine, diaminodiphenylmethane, and diaminodiphenylsulfone. In addition, a curing accelerator may be blended to accelerate the reaction between the epoxy resin and the curing agent, and examples of the curing accelerator include triphenylphosphine, benzyldimethylamine, and 2-methylimidazole.

The following components may be further blended to the present resin composition as necessary. Examples of a stress-lowering agent may include: rubber-like substances such as silicone rubber, polysulfide rubber, acrylic rubber, butadiene rubber, styrene block copolymer, and saturated elastomer; resin substances such as various thermoplastic resins and silicone resins; and further a resin obtained by modifying a part or all of epoxy resin and phenol resin with amino silicone, epoxy silicone, or alkoxy silicone. Examples of a silane coupling agent may include: epoxy silanes such as $\gamma$-glycidoxypropyltrimethoxysilane and $\beta$-(3,4-epoxycyclohexyl)ethyltrimethoxysilane; aminosilanes such as aminopropyltriethoxysilane, ureidopropyltriethoxysilane, and N-phenylaminopropyltrimethoxysilane; hydrophobic silane compounds such as phenyltrimethoxysilane, methyltrimethoxysilane, and octadecyltrimethoxysilane; and mercaptosilane. Examples of a surface treatment agent may include Zr chelate, titanate coupling agent, and aluminum coupling agent. Examples of a flame-retardant auxiliary include $Sb_2O_3$, $Sb_2O_4$, and $Sb_2O_5$. Examples of a flame retardant include halogenated epoxy resins and phosphorus compounds. Examples of a coloring agent include carbon black, iron oxide, dye, and pigment. Furthermore, examples of a releasing agent include natural waxes, synthetic waxes, metal salts of linear fatty acids, acid amides, esters, and paraffin.

The present resin composition may be manufactured by blending a predetermined amount of each of the above materials with a blender or Henschel mixer, then cooling those obtained by kneading e.g., with a heating roll, a kneader, or a single-screw or twin-screw extruder, and then performing pulverization.

In the embodiment of the present invention, a semiconductor sealing material may also be provided. For the semiconductor sealing material, among the above materials, the resin composition preferably consists of a composition including an epoxy resin, a curing agent for the epoxy resin, and a curing accelerator for the epoxy resin. In order to seal a semiconductor by using the present semiconductor sealing material, conventional molding means such as a transfer molding method and a vacuum printing molding method may be adopted.

Examples

Hereinafter, the present invention will be described in more detail with reference to Examples and Comparative Examples.

Examples 1 to 8 and Comparative Examples 1 to 7

Among the Examples 1 to 8, Examples 1 and 2 have an average particle diameter within the range as claimed. The other Examples are outside this range.

Amorphous silica powder was produced by using apparatus that was provided with an LPG-oxygen mixed burner having a double tube structure capable of forming an internal flame and an external flame at the upper portion of a combustion furnace and was directly connected to a capture line consisting of a cyclone and a bag filter at the bottom. The flame was formed by providing dozens of pores at the outlet of the double tube burner and injecting a mixed gas of LPG having 8 m$^3$/Hr and oxygen having 50 m$^3$/Hr therefrom, and through the center of the burner, crystalline silica powder having an average particle size of 4 to 55 $\mu$m was injected at a supply rate of 10 to 40 kg/Hr while accompanied by carrier oxygen having 5 m$^3$/Hr. The amorphous silica powder that passed through the flame was pneumatically transported through a capture line by a blower and collected by the cyclone and the bag filter. The average particle size and the maximum particle size were controlled by adjusting the average particle size of the crystalline silica powder, by appropriately combining the amorphous silica powder of each particle size collected by the cyclone and the bag filter, and then by sieving with a sieve with various apertures for JIS standard stainless steel test. The average sphericity was controlled by adjusting the supply rate of the crystalline silica powder. Specifically, in increasing the sphericity, the supply rate of the crystalline silica powder was decreased, and in decreasing the sphericity, the supply rate of the crystalline silica powder was increased.

Treatment of removing magnetizable particles in various amorphous silica powders manufactured as described above was performed by the following method. Various amorphous silica powders and ion exchange water at 25°C were mixed, and 40 L of a water slurry having a concentration of the amorphous silica powder of 30% by mass, 40% by mass, or 50% by mass was manufactured and put into a 100 L resin container. The slurry in the resin container was stirred by using a stirrer, "Lab stirrer LR500B (all PTFE coated, stirring bar with 100 mm long blade)", manufactured by Yamato Scientific Co., Ltd. at a rotational speed of 300 rpm. Separately, in an electromagnetic iron removal machine capable of wet treatment, 10 or 40 screens having a mesh structure with an aperture of 0.3 mm, 0.5 mm, 1 mm, 15 mm, or 20 mm were stacked vertically, and the exciting current of the electromagnetic iron removal machine was set so that the magnetic force of each screen was 13000 gausses, 14000 gausses, or 14500 gausses. The volume of the magnetic separation zone was 25 L. A tube pump, "704U IP55 Washdown", manufactured by Watson-Marlow Co., Ltd. was provided between the resin container including the water slurry containing the amorphous silica powder and the electromagnetic iron removal machine, and the water slurry containing the amorphous silica powder was circulated through the magnetic separation zone of the electromagnetic iron removal machine at a flow rate of 0.1 cm/s, 0.2 cm/s, 5 cm/s, or 6 cm/s for 60 minutes from the bottom to the top to remove magnetizable particles included in the amorphous silica powder. The line connecting the resin container and the electromagnetic iron removal machine was a resin hose having an inner diameter of 19 mm$\phi$, and the line length was 5 m.

A drying treatment of the amorphous silica powder slurry from which magnetizable particles had been removed was performed by the following method. The temperature in a cylindrical container was set to 120°C, 130°C, or 300°C, and a two-fluid nozzle was provided at the upper portion of the cylindrical container provided with a capture line consisting of a bag filter at a lower portion thereof, and a water slurry containing the amorphous silica powder after removal of magnetizable particles was fed through the center portion of the two-fluid nozzle, and dry air was injected through the outer portion of the two-fluid nozzle, and the slurry was sprayed at a slurry droplet spray speed of 45 m/s, 50 m/s, 250 m/s, or 300 m/s to dry the slurry including the amorphous silica powder. The dried amorphous silica powder was collected by the bag filter. The cylindrical container, the capture line, and the bag filter collection port were lined with alumina, and the inside of the bag filter was lined with natural rubber.

For each of the 15 types of amorphous silica powders A to O produced through the above steps, the average particle size, the percent retention of 250 $\mu$m or more by dry sieving, the number of magnetizable particles having a size of 45 $\mu$m or more, the maximum particle size, and the average sphericity of particles with a particle size of 10 $\mu$m or more are shown in Table 1 and Table 2. The amorphous proportion of all the amorphous silica powders was 99% or more. In the magnetizable particle-removing step, when the aperture of the screens was 0.3 mm and the passing speed through the magnetic separation zone was 0.1 cm/s, the screens were clogged with the slurry containing the amorphous silica powder, thus failing to perform removal treatment of magnetizable particles and to manufacture the amorphous silica powder. In the drying step, when the temperature of the cylindrical container was 120°C inside the cylindrical machine and the spray speed of the slurry droplet was 300 m/s, water evaporation of the slurry containing the amorphous silica powder was insufficient, thus failing to perform drying treatment and to manufacture the amorphous silica powder. For each of these amorphous silica powders, the average particle size, the percent retention of 250 $\mu$m or more by dry sieving, the number of magnetizable particles having a size of 45 $\mu$m or more, the maximum particle size, and the average sphericity of particles with a particle size of 10 $\mu$m or more are shown in Table 1 and Table 2.

Comparative Examples 8 and 9

As further Comparative Examples, two types of amorphous silica powders P and Q which were produced by the above flame melting and which had not undergone the magnetizable particle-removing step and the drying step were also prepared.

Evaluation

To evaluate the properties of the obtained amorphous silica powder as a filling material for a semiconductor sealing material, in 2610 g of an amorphous silica powder, 194 g of a biphenyl epoxy resin (YX-4000H, manufactured by Mitsubishi Chemical Corporation) as an epoxy resin, 169 g of phenol aralkyl resin (Mirex XLC-4L, manufactured by Mitsui Chemicals, Inc.), 10 g of an epoxy silane (KBM-403, manufactured by Shin-Etsu Chemical Co., Ltd.) as a coupling agent, 9 g of triphenylphosphine (TPP, manufactured by Hokko Chemical Co., Ltd.) as a curing accelerator, and 8 g of wax (Licowax-E, manufactured by Clariant, Co., Ltd.) as a releasing agent were added, and dry blending was performed with a Henschel mixer ("FM-10B", manufactured by Mitsui Miike Koki Co., Ltd.) at 1000 rpm for 1 minute. Thereafter, heating and kneading were performed by a co-rotating twin screw extruder (screw diameter D = 25 mm, kneading disc length of 10D mm, paddle rotation speed of 50 to 150 rpm, discharge rate of 3.3 kg/Hr, temperature of a material to be kneaded of $98\pm1°C$). The kneaded material (discharged material) was pressed with a press machine and cooled, and then pulverized and compressed to manufacture a tablet for a semiconductor sealing material (18 mm$\phi$, 32 mmH) to evaluate the insulation reliability (the number of short-circuit failures of the semiconductor) and the moldability (the amount of wire flow) as follows. These results are shown in Tables 1 and 2. In order to avoid inclusion of magnetizable particles derived from equipment and instruments for manufacturing the semiconductor sealing materials, all of the parts being in contact with each material were formed from any of alumina, tungsten carbide, and urethane.

(1) Number of short-circuit failures of a semiconductor

A TEG chip having a size of 8 mm $\times$ 8 mm $\times$ 0.3 mm was placed on a substrate for BGA through a die attach film and connected with gold wire, and then each of the above tablet for the semiconductor sealing material was used and a transfer molding machine was used to perform molding to a package size of 38 mm $\times$ 38 mm $\times$ 1.0 mm, and post cure was performed to manufacture a simulated semiconductor. The gap on the chip was 200 $\mu$m, the diameter of the gold wire was 20 $\mu$m$\phi$, and the connection interval was 55 $\mu$m. The transfer molding conditions were a mold temperature of 175°C, a molding pressure of 7.5 MPa, and a dwell time of 90 seconds, and the post cure conditions were 175°C for 8 hours. Thirty (30) chips of simulated semiconductors were manufactured for the same tablet for the semiconductor sealing material, and the number of semiconductors having a short circuit failure was counted. This number is smaller, showing that the insulation property is better. Specifically, the number of short-circuit failures is preferably zero.

(2) Amount of wire flow

The gold wire portion of the simulated semiconductor manufactured above was observed with a soft X-ray transmission device, and the maximum distance of the gold wire flowed by packaging was measured. The amount of gold wire flow was regarded as the maximum distance of the gold wire flowed before and after packaging, and the average value for 12 gold wires was determined in the order from the gate part (the part where the semiconductor sealing material was injected into the mold) and was regarded as the amount of wire flow. The value of the wire flow amount is smaller, representing that the moldability is better. Specifically, the amount of wire deformation is preferably 25 $\mu$m or less, and more preferably less than 25 $\mu$m.

[Table 1]

| | Examples | | | | | | | |
|---|---|---|---|---|---|---|---|---|
| | 1 | 2 | 3 | 4 | 5 | 6 | 7 | 8 |
| Symbol of amorphous silica powder | A | B | C | D | E | F | G | H |

(continued)

| | | Examples | | | | | | | |
|---|---|---|---|---|---|---|---|---|---|
| | | 1 | 2 | 3 | 4 | 5 | 6 | 7 | 8 |
| Conditions for the magnetizable particle-removing step | Aperture of screens (mm) | 0.5 | 0.5 | 1 | 1 | 1 | 1 | 15 | 15 |
| | Number of screens (sheet) | 10 | 10 | 40 | 40 | 40 | 10 | 40 | 40 |
| | Magnetic force of each screen (gauss) | 14500 | 14000 | 14500 | 14000 | 14000 | 14000 | 14500 | 14000 |
| | Concentration of amorphous silica powder in slurry (% by mass) | 40 | 40 | 30 | 40 | 40 | 40 | 30 | 40 |
| | Passing speed through magnetic separation zone (cm/s) | 0.2 | 5 | 0.2 | 0.2 | 0.2 | 5 | 5 | 5 |
| Conditions for the drying step | Temperature in a cylindrical container (°C) | 130 | 130 | 300 | 300 | 300 | 130 | 300 | 300 |
| | Spray speed of slurry droplets (m/s) | 50 | 250 | 250 | 50 | 50 | 250 | 50 | 50 |
| Properties of amorphous silica powder | Average particle size ($\mu$m) | 23 | 35 | 3 | 5 | 7 | 50 | 4 | 36 |
| | Percent retention of 250 $\mu$m or more by dry sieving (% by mass) | 3.0 | 1.5 | 4.0 | 2.5 | 3.5 | 0.0 | 5.0 | 0.5 |
| | Number of magnetizable foreign matters (-) | 0 | 0 | 0 | 0 | 0 | 0 | 0 | 0 |
| | Maximum particle size ($\mu$m) | 63 | 63 | 53 | 63 | 63 | 75 | 53 | 90 |
| | Average sphericity of particles having a size of 10 $\mu$m or more (-) | 0.90 | 0.83 | 0.85 | 0.91 | 0.80 | 0.81 | 0.79 | 0.85 |
| Properties of semiconductor sealing material | Number of semiconductor defects (-) | 0 | 0 | 0 | 0 | 0 | 0 | 0 | 0 |
| | Wire flow ($\mu$m) | 16 | 15 | 21 | 15 | 21 | 20 | 24 | 25 |

[Table 2]

| | | Comparative Examples | | | | | | | | |
|---|---|---|---|---|---|---|---|---|---|---|
| | | 1 | 2 | 3 | 4 | 5 | 6 | 7 | 8 | 9 |
| Symbol of amorphous silica powder | | I | J | K | L | M | N | O | P | Q |
| Conditions for the magnetizable particle-removing step | Aperture of screens (mm) | 0.5 | 1 | 1 | 15 | 20 | 1 | 20 | | |
| | Number of screens (sheets) | 10 | 40 | 10 | 10 | 10 | 10 | 40 | | |
| | Magnetic force of each screen (gauss) | 14000 | 14000 | 14000 | 13000 | 14000 | 14500 | 14000 | | |
| | Concentration of amorphous silica powder in slurry (% by mass) | 40 | 40 | 50 | 40 | 40 | 50 | 50 | | |
| | Passing speed through magnetic separation zone (cm/s) | 6 | 0.2 | 5 | 0.2 | 5 | 6 | 0.2 | | |
| Conditions of the drying step | Temperature in a cylindrical container (°C) | 130 | 130 | 300 | 300 | 300 | 300 | 300 | | |
| | Spray speed of slurry droplet (m/s) | 50 | 45 | 50 | 50 | 50 | 50 | 45 | | |
| Properties of amorphous silica powder | Average particle size ($\mu$m) | 2 | 39 | 45 | 41 | 6 | 53 | 4 | 34 | 2 |
| | Percent retention of 250 $\mu$m or more by dry sieving (% by mass) | 4.5 | 5.5 | 4.0 | 4.5 | 4.5 | 3.5 | 7.0 | 3.5 | 4.5 |
| | Number of magnetizable foreign matters (-) | 2 | 0 | 2 | 3 | 3 | 3 | 5 | 33 | 21 |
| | Maximum particle size ($\mu$m) | 53 | 75 | 75 | 90 | 75 | 75 | 75 | 75 | 53 |
| | Average sphericity of particles having a size of 10 $\mu$m or more (-) | 0.80 | 0.79 | 0.80 | 0.80 | 0.78 | 0.80 | 0.82 | 0.80 | 0.80 |
| | Number of semiconductor defect (-) | 3 | 0 | 4 | 4 | 5 | 4 | 6 | 20 | 18 |
| Properties of semiconductor sealing material | Wire flow ($\mu$m) | 33 | 35 | 22 | 25 | 24 | 35 | 38 | 22 | 35 |

As is clear from the comparison between Examples and Comparative Examples, the semiconductor sealing material including the amorphous silica powder according to Examples of the present invention may cause no short circuit of the semiconductor and reduce the amount of wire deformation. As described above, according to the present invention, it is possible to provide a semiconductor sealing material suitably used for a miniaturized and high density semiconductor.

Industrial Applicability

The amorphous silica powder of the present invention is used as a filling material for a semiconductor sealing material used for automobiles, personal computers, mobile terminals typified by smartphones and tablets, and laminates on which semiconductors are mounted. In addition, the resin composition of the present invention may be used as, for example, a prepared for a printed circuit board obtained by impregnating and hardening a glass woven fabric, a glass nonwoven fabric, and other organic base materials, and various engineering plastics, in addition to the semiconductor sealing material.

## Claims

1.  An amorphous silica powder having an average particle size of 20 $\mu$m or more and 35 $\mu$m or less, wherein

    a percent retention of 250 $\mu$m or more by dry sieving is 5.0% by mass or less, and
    a number of magnetizable particles having a size of 45 $\mu$m or more is zero as measured by the following method: 50 g of an amorphous silica powder and 800 g of ion exchange water are added in a 1000 mL beaker to prepare a slurry; then
    the slurry is stirred by a stirring device at a rotation speed of 550 rpm and with reverse rotation at intervals of 5 seconds, while a bar magnet having a length of 150 mm, a diameter of 25 mm, and a magnetic force of 12000 gausses which is covered with a rubber cover having a thickness of 20 $\mu$m is immersed therein for 1 minute to capture magnetizable particles; then
    the bar magnet capturing the magnetizable particles is removed from the slurry, and the rubber cover is removed from the magnet bar above an empty beaker, and washed with ionexchange water to detach the magnetizable particles, which are then dispersed in water; then
    the resulting dispersion is loaded on a suction filtration device equipped with a 25 mm diameter nylon filter (opening 35 $\mu$m) to collect the magnetizable particles on the nylon filter. The nylon filter having the collected magnetizable particles is set on a microscope, and the number of magnetizable particles having a size of 45 $\mu$m or more is measured among the magnetizable particles collected on the nylon filter while moving the entire area of the filter at a magnification of 100 times.

2.  The amorphous silica powder according to claim 1, wherein a maximum particle size is 75 $\mu$m or less.

3.  The amorphous silica powder according to claim 1 or 2, wherein an average sphericity of particles having a size of 10 $\mu$m or more is 0.80 or more.

4.  A method of producing the amorphous silica powder according to any one of claims 1 to 3, comprising the steps of:

    using water at 60°C or less to prepare a water slurry having an amorphous silica powder concentration of 40% by mass or less;
    circulating the water slurry from bottom to top at a flow rate of 0.2 cm/s or more and 5 cm/s or less through a magnetic separation zone in a circulation line having the magnetic separation zone, in which 10 or more screens having a aperture of 0.5 mm or more and 15 mm or less and each having a magnetic force of 14000 gausses or more are vertically stacked, to remove magnetizable particles included in the amorphous silica powder; and feeding a water slurry containing the amorphous silica powder after removal of the magnetizable particles through a center portion of a two-fluid nozzle from a container set to 130°C or higher and 300°C or lower of inside temperature and having the two-fluid nozzle provided at the upper portion, and at the same time injecting dry air through an outer portion of the two-fluid nozzle to spray-dry the slurry at a spray speed of slurry droplets of 50 m/s or more and 250 m/s or less.

5.  A resin composition comprising the amorphous silica powder according to any one of claims 1 to 3.

**6.** A semiconductor sealing material comprising the resin composition according to claim 5.

**Patentansprüche**

**1.** Amorphes Siliciumdioxidpulver mit einer durchschnittlichen Teilchengröße von 20 $\mu$m oder mehr und 35 $\mu$m oder weniger, wobei

eine prozentuale Retention von 250 $\mu$m oder mehr durch Trockensiebung 5,0 Massen-% oder weniger beträgt, und
eine Anzahl magnetisierbarer Teilchen mit einer Größe von 45 $\mu$m oder mehr null ist, gemessen nach dem folgenden Verfahren:
50 g eines amorphen Siliciumdioxidpulvers und 800 g Ionenaustauschwasser werden in ein 1000-ml-Becherglas gegeben, um eine Aufschlämmung herzustellen; dann
wird die Aufschlämmung mittels einer Rührvorrichtung bei einer Drehzahl von 550 U/min und mit Richtungsumkehr in Intervallen von 5 Sekunden gerührt, während ein Stabmagnet mit einer Länge von 150 mm, einem Durchmesser von 25 mm und einer Magnetkraft von 12000 Gauß, der mit einer Gummihülle mit einer Dicke von 20 $\mu$m bedeckt ist, darin 1 Minute lang eingetaucht wird, um magnetisierbare Teilchen einzufangen; dann wird der Stabmagnet, der die magnetisierbaren Teilchen festhält, aus der Aufschlämmung entfernt, und wird die Gummihülle von dem Magnetstab über einem leeren Becherglas entfernt, und mit Ionenaustauschwasser gewaschen, um die magnetisierbaren Teilchen abzulösen, die anschließend in Wasser dispergiert werden; dann wird die sich ergebende Dispersion auf eine Saugfiltrationsvorrichtung gegeben, die mit einem Nylonfilter mit einem Durchmesser von 25 mm (Öffnung 35 $\mu$m) ausgestattet ist, um die magnetisierbaren Teilchen auf dem Nylonfilter zu sammeln. Der die gesammelten magnetisierbaren Teilchen aufweisende Nylonfilter wird auf ein Mikroskop gesetzt und die Anzahl magnetisierbarer Teilchen mit einer Größe von 45 $\mu$m oder mehr innerhalb der auf dem Nylonfilter gesammelten magnetisierbaren Teilchen wird gemessen, während die gesamte Fläche des Filters bei 100-facher Vergrößerung bewegt wird.

**2.** Amorphes Siliciumdioxidpulver nach Anspruch 1, wobei eine maximale Teilchengröße 75 $\mu$m oder weniger beträgt.

**3.** Amorphes Siliciumdioxidpulver nach Anspruch 1 oder 2, wobei eine durchschnittliche Sphärizität von Teilchen mit einer Größe von 10 $\mu$m oder mehr 0,80 oder mehr beträgt.

**4.** Verfahren zum Herstellen des amorphen Siliciumdioxidpulvers nach einem der Ansprüche 1 bis 3, umfassend die folgenden Schritte:

Verwenden von Wasser mit 60 °C oder weniger zur Herstellung einer Wasseraufschlämmung mit einer Konzentration an amorphem Siliciumdioxidpulver von 40 Massen-% oder weniger;
Zirkulierenlassen der Wasseraufschlämmung von unten nach oben bei einer Durchflussrate von 0,2 cm/s oder mehr und 5 cm/s oder weniger durch eine magnetische Abscheidungszone in einer Zirkulationsleitung, die die magnetische Abscheidungszone aufweist, in der 10 oder mehr Siebe mit einer Öffnung von 0,5 mm oder mehr und 15 mm oder weniger und jeweils mit einer Magnetkraft von 14000 Gauß oder mehr vertikal gestapelt sind, um in dem amorphen Siliciumdioxidpulver enthaltene magnetisierbare Teilchen zu entfernen; und
Zuführen einer das amorphe Siliciumdioxidpulver enthaltenden Wasseraufschlämmung nach Entfernung der magnetisierbaren Teilchen durch einen mittleren Abschnitt einer Zweistoffdüse von einem Behälter, der auf eine Innentemperatur von 130 °C oder höher und 300 °C oder niedriger eingestellt ist und an dem die Zweistoffdüse an dem oberen Abschnitt vorgesehen ist, und gleichzeitig Einblasen trockener Luft durch einen äußeren Abschnitt der Zweistoffdüse, um die Aufschlämmung mit einer Sprühgeschwindigkeit der Aufschlämmungströpfchen von 50 m/s oder mehr und 250 m/s oder weniger sprühzutrocknen.

**5.** Harzzusammensetzung, umfassend das amorphe Siliciumdioxidpulver nach einem der Ansprüche 1 bis 3.

**6.** Halbleiterabdichtmaterial, umfassend die Harzzusammensetzung nach Anspruch 5.

**Revendications**

**1.** Poudre de silice amorphe ayant une taille particulaire moyenne égale ou supérieure à 20 $\mu$m et inférieure ou égale à 35 µm, où

un pourcentage de rétention par tamisage à sec de particules d'une taille égale ou supérieure à 250 µm est inférieur ou égal à 5,0 % en masse, et

un nombre de particules magnétisables ayant une taille égale ou supérieure à 45 µm est zéro, tel que mesuré par la méthode suivante, :

50 g d'une poudre de silice amorphe et 800 g d'une eau échangeuse d'ions sont ajoutés dans un bécher de 1 000 ml pour préparer une suspension épaisse ; puis

la suspension épaisse est agitée au moyen d'un dispositif d'agitation à une vitesse de rotation de 550 tr/min et avec inversion de la rotation à des intervalles de 5 secondes, et un barreau magnétique ayant une longueur de 150 mm, un diamètre de 25 mm et une force magnétique de 12 000 Gauss, qui est couvert avec un manchon en caoutchouc d'une épaisseur de 20 µm, est immergé dans celle-ci pendant 1 minute pour capter les particules magnétisables ; puis

le barreau magnétique captant les particules magnétisables est retiré de la suspension épaisse et le manchon en caoutchouc est retiré du barreau magnétique en dessus d'un bécher vide et lavé avec une eau échangeuse d'ions pour détacher les particules magnétisables qui sont ensuite dispersées dans l'eau ; puis

la dispersion résultante est chargée sur un dispositif de filtration par aspiration équipé d'un filtre en nylon d'un diamètre de 25 mm (pores de 35 µm) pour recueillir les particules magnétisables sur le filtre en nylon. Le filtre en nylon sur lequel les particules magnétisables ont été recueillies est placé sur un microscope et le nombre de particules magnétisables d'une taille égale ou supérieure à 45 µm est mesuré parmi les particules magnétisables recueillies sur le filtre en nylon tout en déplaçant l'aire totale du filtre à un grossissement de 100 fois.

2. Poudre de silice amorphe selon la revendication 1, où une taille particulaire maximale est inférieure ou égale à 75 µm.

3. Poudre de silice amorphe selon la revendication 1 ou 2, où la sphéricité moyenne des particules ayant une taille égale ou supérieure à 10 µm est de 0,80 ou plus.

4. Méthode de production de la poudre de silice amorphe selon l'une quelconque des revendications 1 à 3, comprenant les étapes suivantes :

utilisation d'une eau à 60 °C ou moins pour préparer une suspension aqueuse épaisse ayant une concentration en poudre de silice amorphe inférieure ou égale à 40 % en masse ;

faire circuler la suspension aqueuse épaisse à un débit de 0,2 cm/s ou plus et de 5 cm/s ou moins du bas au sommet au travers d'une zone de séparation magnétique dans une conduite de circulation comportant la zone de séparation magnétique dans laquelle 10 tamis ou plus dont l'ouverture des pores est égale ou supérieure à 0,5 mm et inférieure ou égale à 15 mm et ayant chacun une force magnétique de 14 000 Gauss ou plus sont empilés verticalement pour retirer les particules magnétisables contenues dans la poudre de silice amorphe ; et

transfert d'une suspension aqueuse épaisse contenant la poudre de silice amorphe de laquelle les particules magnétisables ont été retirées au travers d'une portion centrale d'une buse à deux tuyères depuis un conteneur dont la température interne est fixée à 130 °C ou plus et 300 °C ou moins qui comporte la buse à deux tuyères dans la partie haute, et injection simultanée d'air sec au travers d'une partie externe de la buse à deux tuyères pour sécher par pulvérisation la suspension épaisse à une vitesse de pulvérisation des gouttelettes de suspension épaisse de 50 m/s ou plus et de 250 m/s ou moins.

5. Composition résinique comprenant la poudre de silice amorphe selon l'une quelconque des revendications 1 à 3.

6. Matériau d'encapsulation de semiconducteurs comprenant la composition résinique selon la revendication 5.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007005346 A
- JP 2005187302 A
- EP 0257611 A2
- JP 2010285307 A
- JP 5994573 B
- JP H11057451 A

**Non-patent literature cited in the description**

- **LEI XUE et al.** Synthesis of Monodisperse Silica Microspheres by a Modified Stöber Method. *Integrated Ferroelectrics,* 2014, vol. 154 (1), 142-146
- **HE JIE et al.** Preparation and characterization of monodisperse porous silica microspheres with controllable morphology and structure. *J. Polymer Sci. Part A: Polymer Chem.,* 2012, vol. 50 (14), 2889-2897